# EUROPEAN PATENT APPLICATION

(11) **EP 1 967 314 A1**
(43) Date of publication of application: **10.09.2008**
(21) Application number: 06843050.3
(22) Date of filing: 22.12.2006
(51) Int. Cl.: B23K 1/008

(54) **SOLDERING CONTAINER AND PRODUCTION METHOD OF SEMICONDUCTOR DEVICE**

(30) Priority: 28.12.2005 JP 2005379942
(71) Applicant: KABUSHIKI KAISHA TOYOTA JIDOSHOKKI, Kariya-shi, Aichi 448-8671 (JP)
(72) Inventor: KIMBARA, Masahiko, Kariya-shi, Aichi 4488671 (JP)
(74) Representative: TBK-Patent
(86) International application number: PCT/JP2006/325591
(87) International publication number: WO 2007/077757

(57) **Abstract**

A soldering container configured to be conveyed by a conveyance mechanism during soldering in a state accommodating a soldering subject. The container includes a sealable container body for accommodating the soldering subject. The container body includes at least one communication passage enabling communication between the inside and outside of the container body. The container body is configured to be connectable to an atmospheric adjustment device for adjusting an internal atmosphere of the container body through the communication passage.

## Description

### TECHNICAL FIELD

The present invention relates to a soldering container used when performing soldering and a production method of a semiconductor device.

### BACKGROUND ART

Generally, in a semiconductor module serving as a semiconductor device, a metal plate for forming a wiring plate is bonded to the front surface of a ceramic substrate, and a metal plate for forming a bonding layer is bonded to the rear surface of the ceramic substrate. A semiconductor element is bonded to the metal plate at the front surface side, and a heat sink serving as a radiator for radiating heat generated from the semiconductor element is bonded to the metal plate at the rear surface side. In this type of semiconductor module, the semiconductor element is bonded to the metal plate at the front surface side by performing soldering. A reflow furnace such as that disclosed in patent document 1 is widely known as a device that performs such soldering. The reflow furnace includes a conveyor and a heater. In the reflow furnace, the semiconductor module is heated while being conveyed on the conveyor. This melts solder and performs soldering.

The soldering of a semiconductor element such as a transistor or a diode is normally carried out in an inert gas atmosphere. Accordingly, when soldering a semiconductor element with the reflow furnace, inert gas must be supplied into the furnace to carry out atmospheric adjustment. However, the reflow furnace includes the conveyor, and the entrance and exit of the furnace are open to the ambient air. Thus, to maintain the atmosphere in the reflow furnace, inert gas must be continuously supplied into the furnace. This increases consumption of the inert gas.

To reduce the consumption of the inert gas, soldering may be performed in a sealable container (chamber) in lieu of a non-sealable reflow furnace. In such a case, however, the container would have to be equipped with the components required for soldering such as a heating device so that soldering can be completed in the container. Accordingly, the use of a sealable container to perform soldering is more advantageous than the use of a reflow furnace to perform soldering in that the consumption of gas required for atmospheric adjustment can be reduced. On the other hand, there is a disadvantage in that batch processing would become inevitable. Thus, the sealable container would not be suitable for use in a production line for mass production.
[Patent Document 1] Japanese Laid-Open Patent Publication No. 2001-339152

### DISCLOSURE OF THE INVENTION

It is an object of the present invention to provide a soldering container that reduces the consumption of gas that is required to adjust the atmosphere in a container body and that is suitable for use in a production line. A further object of the present invention is to provide a production method of a semiconductor device that improves production efficiency.

To achieve the above object, one aspect of the present invention provides a soldering container configured to be conveyed by a conveyance mechanism during soldering in a state accommodating a soldering subject. The container includes a sealable container body for accommodating the soldering subject. The container body includes at least one communication passage enabling communication between the inside and outside of the container body. The container body is configured to be connectable to an atmospheric adjustment device for adjusting an internal atmosphere of the container body through the communication passage.

A further aspect of the present invention provides a production method of a semiconductor device by soldering a semiconductor element to a circuit board. The production method includes accommodating in a sealable container body a soldering subject in which the semiconductor element is arranged on the circuit board with solder located therebetween, with the container body including at least one communication passage enabling communication between the inside and outside of the container body. The production method further includes conveying the container body accommodating the soldering subject with a conveyance mechanism, supplying the container body with atmosphere gas containing reducing gas through the communication passage from an atmospheric adjustment device connected to the container body to fill the container body with the atmosphere gas, raising the temperature in the container body to a temperature that is higher than or equal to a melting point of the solder in a state in which the container body is filled with the atmosphere gas to melt the solder, and solidifying the molten solder by lowering the temperature in the container body to a temperature that is lower than the melting point to solder the semiconductor element to the circuit board.

### BRIEF DESCRIPTION OF THE DRAWINGS

Fig. 1 is a plan view of a semiconductor module, which includes a ceramic substrate, according to the present invention;
Fig. 2 is a cross-sectional view taken along line 2-2 of Fig. 1;
Fig. 3 is a vertical, cross-sectional view of a container according to a first embodiment that is used when performing soldering;
Fig. 4 is another vertical cross-sectional view of the container shown in Fig. 3;
Fig. 5(a) is a plan view of a jig used for soldering, and Fig. 5(b) is a perspective view of a weight used for soldering;
Fig. 6 is a schematic diagram showing the layout of a high frequency heating coil relative to a semiconductor module including a plurality of ceramic substrates;
Fig. 7 is a schematic diagram showing a production line for the semiconductor module of the first embodiment;
Fig. 8 is a schematic diagram showing a container according to a second embodiment that is used for soldering;
Fig. 9 is a schematic diagram showing a heating method according to another embodiment; and
Fig. 10 is a schematic diagram showing a heating method according to a further embodiment.

### BEST MODE FOR CARRYING OUT THE INVENTION

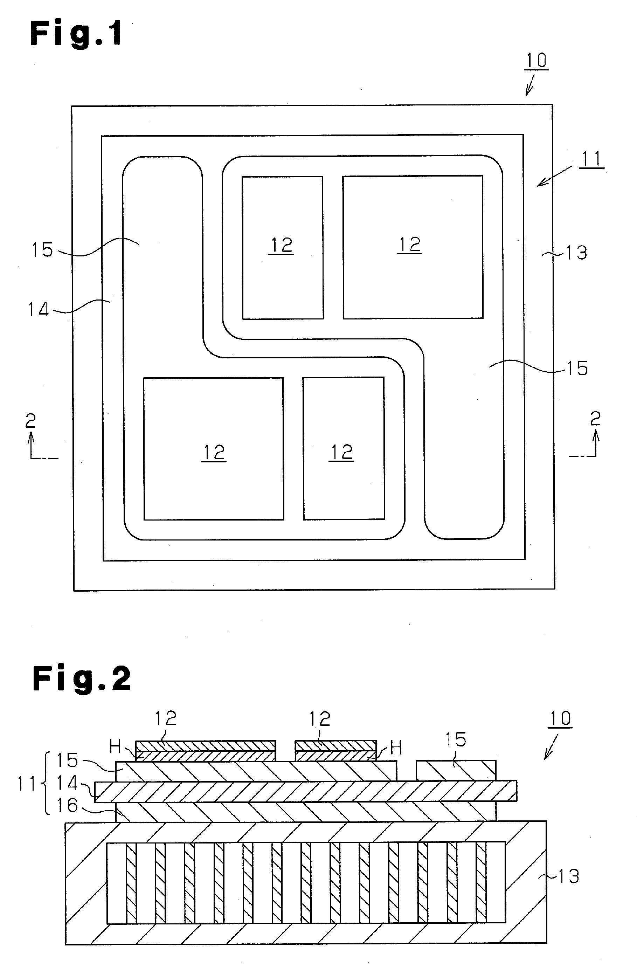

A first embodiment of the present invention will now be discussed with reference to Figs. 1 to 7.

Fig. 1 and Fig. 2 show a semiconductor module 10, which serves as a semiconductor device. The semiconductor module 10 includes a circuit board 11, a plurality of (four in the present embodiment) semiconductor elements 12 bonded to the circuit board 11, and a heat sink 13 serving as a radiator. The circuit board 11 is formed by bonding metal plates 15 and 16 on opposite sides of a ceramic substrate 14. The ceramic substrate 14 is formed from aluminum nitride, alumina, silicon nitride, or the like. The metal plate 15, which functions as a wiring layer, is formed from, for example, aluminum (pure aluminum and aluminum alloy) or copper. The semiconductor elements 12 are bonded (soldered) to the metal plate 15, which has undergone a surface treatment using nickel, phosphor, titanium, or the like. Reference character "H" in Fig. 2 denotes a solder layer. The semiconductor elements 12 include an IGBT (Insulated Gate Bipolar Transistor) and a diode. The metal plate 16 serves as a bonding layer for bonding the ceramic substrate 14 and the heat sink 13 and is formed from, for example, aluminum, or copper. The heat sink 13 is bonded to the metal plate 16.

The above described semiconductor module 10 is soldered after undergoing a plurality of operations on a production line. The semiconductor module 10 (includes an uncompleted product prior to soldering) is accommodated in a container (chamber), and the container is conveyed between operations by a conveyance mechanism such as a conveyor. In the present embodiment, the production of the semiconductor module 10 includes three processes, a gas replacement process serving as a first process, a heating process serving as a second process, and a cooling process serving as a third process. These processes solder the semiconductor elements 12 to the circuit board 11 (metal plate 15) and completes the semiconductor module 10 as a product. In the heating process of the present embodiment, heating is performed by carrying out high frequency induction heating.

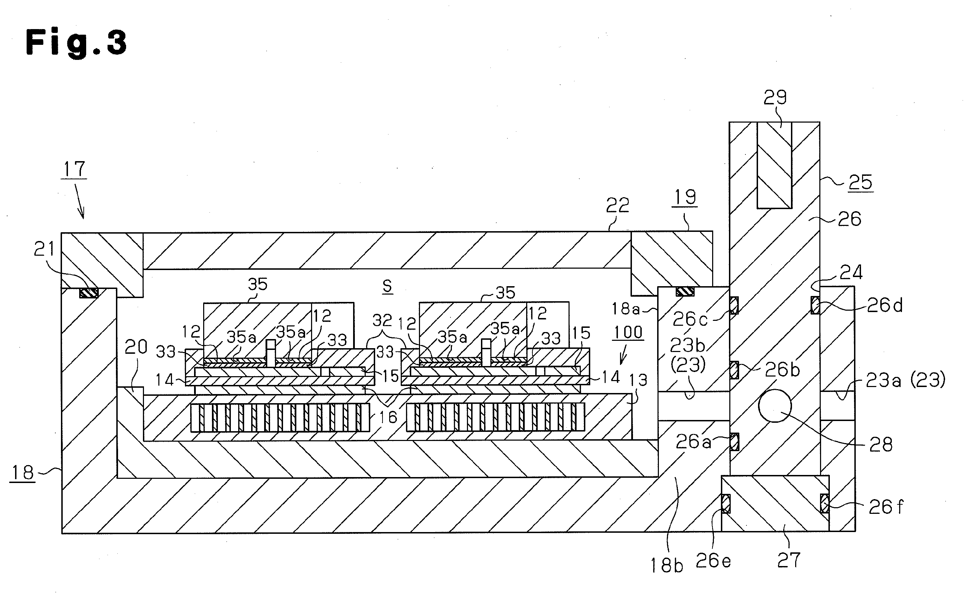

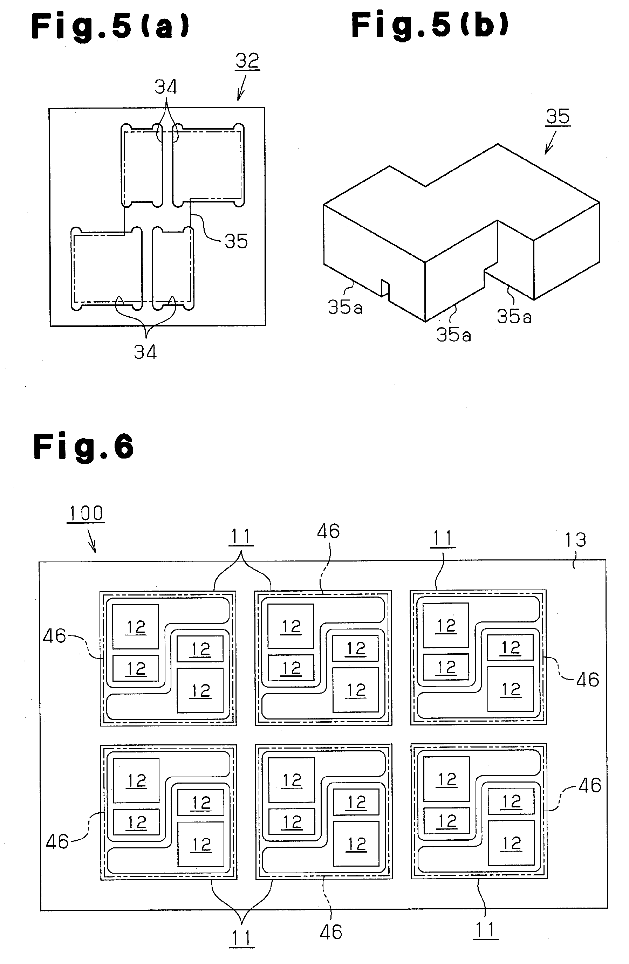

Fig. 3 shows a container (chamber) 17 used for soldering. The container 17 is used when performing soldering on a semiconductor module 100 including six of the circuit boards 11 shown in Fig. 6. In the semiconductor module 100, twenty-four semiconductor elements 12 are soldered. In the same manner as the semiconductor module 10 shown in Figs. 1 and 2, the circuit boards 11 of the semiconductor module 100 each include the ceramic substrate 14 and the metal plates 15 and 16. The semiconductor elements 12 are soldered to the metal plate 15, and the heat sink 13 is bonded to the metal plate 16.

The container 17 includes a box-shaped main body (container body) 18, which has an opening 18a, and a cover 19, which is for opening and closing the opening 18a. A support base 20 for positioning and supporting the semiconductor module 100 is arranged in the main body 18. A packing 21 that comes into contact with the cover 19 is arranged in the open end of the main body 18.

The cover 19 is large enough to close the opening 18a of the main body 18. An accommodation space S is defined in the container 17 when the cover 19 is attached to the main body 18. The cover 19 has a portion 22 facing toward the accommodation space S. The portion 22 is formed from a non-magnetic and electrically insulative material. In this embodiment, glass is used as the electrically insulative material, and the portion 22 of the cover 19 is formed from a glass plate.

A communication hole 23 extends through a side wall 18b of the main body 18. The communication hole 23 functions as a communication passage for communicating the inside and outside of the container 17. A valve chamber 24 is formed in the side wall 18b to divide the communication hole 23 into two, an outer communication hole 23a and an inner communication hole 23b. The outer communication hole 23a, which opens in the outer surface of the side wall 18b, communicates the valve chamber 24 to the outside of the container 17. The inner communication hole 23b, which opens in the inner surface of the side wall 18b, communicates the valve chamber 24 to the inside of the container 17. A manual valve 25 is accommodated in the valve chamber 24. The manual valve 25 functions as a switching unit (valve body) for opening and closing the communication hole 23, that is, switching the outer communication hole 23a and the inner communication hole 23b between states of communication and non-communication.

The manual valve 25 includes a cylindrical valve body 26 and a seat 27 for supporting the valve body 26 rotatably about the axis of the valve body 26. The valve body 26 includes a valve passage 28, which is located at a position flush with the communication hole 23 with respect to the axial direction of the valve body 26. The valve passage 28 has a diameter that is the same as that of the communication hole 23. A ring groove 26a, which has an axis that is orthogonal to the axis of the valve passage 28, is formed in the circumferential surface of the valve body 26. When the valve passage 28 is a state of non-communication with the communication hole 23, that is, when the valve passage 28 is orthogonal to the communication hole 23 (refer to Fig. 3), the ring groove 26a surrounds the outer communication hole 23a or the inner communication hole 23b. A seal ring 26b serving as a seal is arranged in the ring groove 26a so that the outer communication hole 23a and the inner communication hole 23b do not communicate with each other through a gap formed around the valve body 26. A ring groove 26c extending in the circumferential direction of the valve body 26 is formed in the circumferential surface of the valve body 26. A seal ring 26d is arranged in the ring groove 26c. A ring groove 26e extending in the circumferential direction of the seat 27 is formed in the circumferential surface of the seat 27. A seal ring 26f is arranged in the ring groove 26e. Such a seal structure hermetic seals the inside of the container 17.

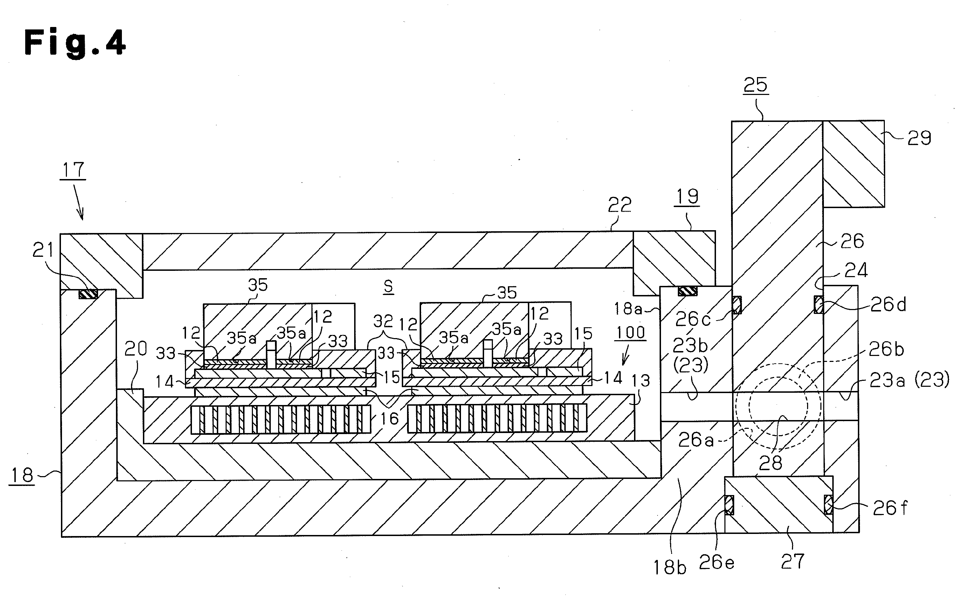

The valve body 26 includes an exposed portion outside the side wall 18b. At the distal end of this portion, an operation lever 29 for rotatably operating the manual valve 25 is arranged. As shown in Fig. 4, the operation lever 29 extends from the circumferential surface of the valve body 26 so that the manual valve 25 can be externally operated (e.g., operated by an external operation device such as a robot).

When the communication hole 23 is closed by operating the manual valve 25, that is, when the outer communication hole 23a and the inner communication hole 23b are in a state of non-communication, the inside of the container 17 is disconnected from the outside of the container 17. In other words, the container 17 is sealed. Fig. 3 shows a state in which the valve passage 28 of the manual valve 25 is oriented in a direction orthogonal to the communication hole 23 thereby disconnecting the inside and outside of the container 17. When the manual valve 25 is operated to open the communication hole 23, that is, when the outer communication hole 23a and the inner communication hole 23b are in communication, the inside of the container 17 is connected to the outside of the container 17. Fig. 4 shows a state in which the valve passage 28 of the manual valve 25 is in communication with the communication hole 23 (outer communication hole 23a and the inner communication hole 23) thereby connecting the inside and the outside of the container 17.

Fig. 5(a) shows a jig 32 used for soldering, and Fig. 5(b) shows a weight 35 serving as a pressurizing body. The jig 32 is flat and has the same size as the ceramic substrate 14 in each circuit board 11. The jig 32 is formed from a material such as graphite or ceramics and is used to position a solder sheet 33, the semiconductor elements 12, and the weight 35 on the circuit board 11 during soldering, as shown in Fig. 3 and Fig. 4. For such a purpose, a plurality of positioning holes 34 extend through the jig 32. The holes 34 are formed in the jig 32 in correspondence with the portion (bonding portion) of the circuit board 11 to which the semiconductor elements 12 are bonded. Each hole 34 has a size corresponding to the size of the corresponding semiconductor element 12. In the present embodiment, a plurality of (four) holes 34 are formed in the jig 32 since a plurality of (four) semiconductor elements 12 are bonded to the circuit board 11.

The weight 35 is formed from a material that emits heat generated by an electromagnetic induction effect, that is, material that generates heat due to its electrical resistance when current is generated by changes in magnetic flux passing therethrough. In the present embodiment, the weight 35 is formed from stainless steel. As shown in Figs. 3 and 4, the weight 35 is arranged immediately above the four semiconductor elements 12 positioned by the jig 32 during soldering and is large enough to come into contact with the upper surfaces (non-bonding surfaces) of the four semiconductor elements 12. The weight 35 is used to press the semiconductor element 12 towards the circuit board 11. The weight 35 of the present embodiment is an integrated component formed through milling. The weight 35 includes a plurality of (four) pressurizing surfaces 35a, which are respectively insertable into the holes 34 of the jig 32 and which contact the non-bonding surfaces (upper surfaces) of the four semiconductor elements 12 to pressurize the corresponding semiconductor element 12. Fig. 5(a) shows a state in which the weight 35 is arranged in the jig 32, with the weight 35 being shown by a double-dotted line.

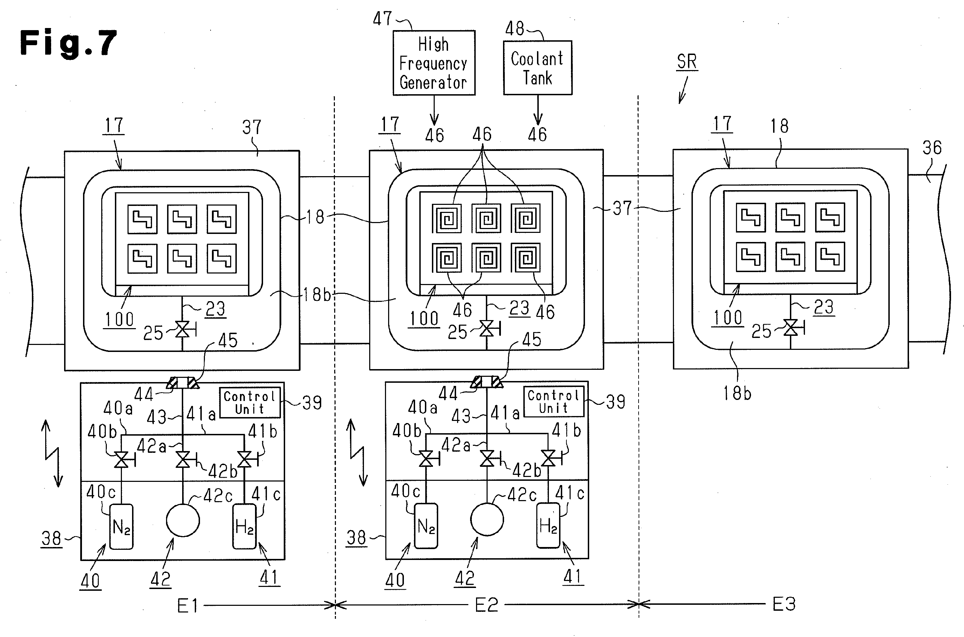

The structure of a production line SR for the semiconductor module 100 will now be discussed with reference to Fig. 7. Fig. 7 schematically shows the production line SR but does not shown the cover 19 of the container 17.

The production line SR includes a conveyor 36 serving as a conveyance mechanism and a plurality of conveying platforms 37 arranged on the conveyor 36. The conveyor 36 conveys the container 17, which is held on each of the plurality of conveying platforms 37. In Fig. 7, the left side is the upstream side of the production line SR, and the right side is the downstream side of the production line SR. The conveying platforms 37 holding the container 17 are moved from the upstream side of the production line SR towards the downstream side of the production line SR while sequentially undergoing predetermined processes. In the production line SR, the semiconductor module 100 becomes closer to a completed product at it moves towards the downstream side. As shown in Fig. 7, three work areas E1, E2, and E3 respectively corresponding to the gas replacement process, the heating process, and the cooling process are provided in the production line SR.

An atmospheric adjustment device 38 for adjusting the internal atmosphere (gas atmosphere) of the container 17, or the accommodation space S, is arranged in the production line SR for each of the work areas E1 and E2, which are for the gas replacement process and the heating process. Each atmospheric adjustment device 38 may be moved toward or away from the container 17 on the conveying platform 37.

Each atmospheric adjustment device 38 includes a control unit 39, an inert gas supply unit 40 for supplying inert gas (nitrogen (N₂) in the present embodiment) into the container 17, a reducing gas supply unit 41 for supplying reducing gas (hydrogen (H₂) in the present embodiment) into the container 17, and a gas discharge unit 42 for discharging gas out of the container 17. The inert gas supply unit 40 includes a pipe 40a, an open/close valve 40b arranged in the pipe 40a, and a nitrogen tank 40c. The reducing gas supply unit 41 includes a pipe 41a, an open/close valve 41b arranged in the pipe 41a, and a hydrogen tank 41c. The gas discharge unit 42 includes a pipe 42a, an open/close valve 42b arranged in the pipe 42a, and a vacuum pump 42c. The control unit 39 is connected to the open/close valves 40b, 41b, and 42b and to the vacuum pump 42c to control the valves 40b, 41b, and 42b, and the pump 42c and perform atmospheric adjustment in the container 17. That is, the atmospheric adjustment device 38 controls the gas supplied to and discharged from the container 17 to adjust the gas flow rate and the internal pressure of the container 17 in addition to replacing the air in the container 17 with inert gas.

The atmospheric adjustment device 38 includes a connection pipe 43 connected to the communication hole 23 of the container 17, specifically, the outer communication hole 23a. The connection pipe 43 is connected to the pipe 40a of the inert gas supply unit 40, the pipe 41a of the reducing gas supply unit 41, and the pipe 42a of the gas discharge unit 42. The connection pipe 43 includes a connection port 44, and the connection pipe 43 is connected to the communication hole 23 of the container 17 by the connection port 44. A seal 45 for preventing gas leakage from the connection of the connection pipe 43 and the communication hole 23 is arranged in the connection port 44.

In the production line SR, a plurality of high frequency heating coils 46 serving as a heating device are arranged in the work area E2 for the heating process. The high frequency heating coils 46 are located above the container 17, which has been moved into the work area E2, and heats the weight 35 from outside the container 17 to melt the solder sheets 33. A high frequency generator 47 and a coolant tank 48 are arranged in the work area E2 for the heating process.

In the present embodiment, as shown in Fig. 6, six high frequency heating coils 46 are respectively arranged above and in correspondence with the six circuit boards 11 of the semiconductor module 100. Each high frequency heating coil 46 is large enough to cover one circuit board 11 and is larger than the contour of the upper surface of the weight 35, which will be described later, when seen from above. The high frequency heating coils 46 are each spirally wound on a plane so as to have a substantially tetragonal shape as a whole. The high frequency heating coils 46 are arranged facing toward the glass plate 22 of the cover 19. The high frequency heating coils 46 are electrically connected to the high frequency generator 47. Further, each high frequency heating coil 46 includes a cooling passage (not shown) through which coolant flows, and each high frequency heating coil 46 is connected to the coolant tank 48.

An external operation device (not shown) for opening and closing the manual valve 25 of the container 17 is arranged in the work areas E1, E2, and E3 for each process in the production line SR. The external operation device includes, for example, a robot and a control unit for controlling the operation of the robot.

A production method of the semiconductor elements 12 in the production line SR of the present embodiment will now be described. In the present embodiment, soldering is performed on a subject that bonds six circuit boards 11 to the heat sink 13, that is, on a soldering subject. The soldering subject is an uncompleted product and corresponds to the semiconductor module 100 with the six circuit boards 11 but less the semiconductor elements 12.

When performing soldering, an empty container 17 in which a soldering subject or a completed semiconductor module 100 is not accommodated in the accommodation space S is first prepared. The cover 19 is removed from the main body 18 of the container 17 to open the opening 18a. The soldering subject is arranged on and positioned on the support base 20 in the main body 18, as shown in Fig. 3. The jigs 32 are then arranged on the circuit boards 11 of the soldering subject, specifically, on the ceramic substrate 14. The solder sheet 33 and the semiconductor element 12 are arranged in each hole 34 of the jigs 32. The solder sheet 33 is arranged between the corresponding circuit board 11, specifically, the metal plate 15, and semiconductor element 12. The weights 35 are placed on the circuit boards 11, on which the semiconductor elements 12 are arranged. In this state, the solder sheet 33, the semiconductor elements 12, and the weight 35 are sequentially stacked from the metal plate 15 on the circuit board 11, specifically, the metal plate 15. The solder sheet 33, the semiconductor element 12, and the weight 35 are stacked in the vertical direction (upward direction in Fig. 3) of the container 17. The pressurizing surfaces 35a of the weight 35 contacts the non-bonding surfaces of the corresponding semiconductor elements 12 and pressurizes the corresponding semiconductor elements 12.

The cover 19 is then attached to the main body 18 to close the opening 18a. The container 17 is arranged on a conveying platform 37 of the conveyor 36 and first conveyed to the work area E1 for the gas replacement process. In the work area E1, the connection pipe 43 of the atmospheric adjustment device 38 is connected to the communication hole 23 (outer communication hole 23a) of the container 17. The atmospheric adjustment device 38 performs gas replacement (atmospheric adjustment) inside the container 17. When carrying out the gas replacement, the external operation device (not shown) opens the manual valve 25 of the container 17, and the communication hole 23 opens as shown in the state of Fig. 4. That is, the valve passage 28 communicate the outer communication hole 23a and the inner communication hole 23b. The open/close valves 40b, 41b, and 42b in the atmospheric adjustment device 38 are closed before the gas replacement process is started.

In the gas replacement process, the control unit 39 of the atmospheric adjustment device 38 opens the open/close valve 42b of the gas discharge unit 42 and operates the vacuum pump 42c. This depressurizes the container 17. The control unit 39 then closes the open/close valve 42b, deactivates the vacuum pump 42c, and opens the open/close valve 40b of the inert gas supply unit 40 to supply and fill the accommodation space S of the container 17 with inert gas (nitrogen). After supplying inert gas, the control unit 39 controls closes the open/close valve 42b to stop the supply of inert gas. The control unit 39 repeats the depressurization and supply of nitrogen a few times. Then, the control unit 39 opens the open/close valve 41b of the reducing gas supply unit 41 to supply and fill the accommodation space S with reducing gas (hydrogen). When the accommodation space S becomes a reducing gas atmosphere, the control unit 39 closes the open/close valve 41b to stop the supply of reducing gas. In the gas replacement process, atmospheric adjustment is performed in the container 17 by carrying out these procedures.

After the gas replacement process ends, the external operation device (not shown) closes the manual valve 25. This closes the communication hole 23, that is, disconnects the outer communication hole 23a and the inner communication hole 23b, as shown in the state of Fig. 3. The atmospheric adjustment device 38 is disconnected and separated from the container 17. The container 17 subsequent to gas replacement is conveyed to the work area E2 for the heating process, which is the process following the gas replacement process, by the conveyor 36 while remaining on the conveying platform 37.

After reaching the work area E2 for the heating process, the container 17 is arranged immediately below the plurality of high frequency heating coils 46. In this state, the high frequency heating coils 46 are arranged above the soldering subjects as shown in Fig. 6. The glass plate 22 in the cover 19 is arranged between the high frequency heating coils 46 and the corresponding soldering subjects. The high frequency heating coil 46, which is spirally wound in the present embodiment generates a large amount of magnetic flux near its central part. Thus, the weight 35, or the bonding portion of the circuit board 11, is preferably arranged in correspondence with the middle of the high frequency heating coil 46. Further, in the same manner as in the gas replacement process, the atmospheric adjustment device 38 is connected to the communication hole 23 of the container 17.

In the heating process, the high frequency generator 47 is operated to generate high frequency current that flows to each high frequency heating coil 46. The high frequency heating coil 46 generates high frequency magnetic flux that passes through the corresponding weight 35, and eddy current is generated in the weight 35. As a result, the electromagnetic induction effect heats the weight 35, and heat is transmitted from the pressurizing surfaces 35a of the weight 35 to the semiconductor elements 12. The heat is transmitted to each solder sheet 33 in a concentrated manner. This heats the solder sheet 33 to a temperature that is higher than or equal to the melting point and melts the solder sheet 33. The semiconductor elements 12 are pressed towards the circuit board 11 by the weight 35 and thus are not displaced by the surface tension of the melted solder. When the solder sheet 33 completely melts, the high frequency generator 47 is deactivated. In the heating process, the internal atmosphere of the container 17 is adjusted, that is, the internal pressure of the container 17 is adjusted by the atmospheric adjustment device 38 in accordance with progress of the soldering. In the heating process, the temperature inside the container 17 is raised to become higher than or equal to the solder melting point in a state in which the container 17 is filled with reducing gas, or hydrogen.

When the heating process ends, the external operation device (not shown) closes the manual valve 25 of the container 17. This closes the communication hole 23, that is, disconnects the outer communication hole 23a and the inner communication hole 23b as shown in the state of Fig. 3. The atmospheric adjustment device 38 is then disconnected and separated from the container 17. The container 17 subsequent to the heating process is conveyed as to the work area E3 for the cooling process, which is the process following the heating process while remaining on the conveyor 36.

After reaching the work area E3 for the cooling process, the container 17 is cooled while the molten solder solidifies. The molten solder solidifies when cooled to lower than the melting point thereby bonding the metal plate 15 and the semiconductor elements 12. This ends the soldering and completes the semiconductor module 100. In the cooling process, the temperature in the container 17 becomes lower than the melting point of the solder. After the cooling process, the cover 19 is removed from the main body 18, the jigs 32 and weights 35 are removed from the circuit board 11, and the semiconductor module 100 is taken out from the container 17. Before taking out the semiconductor module 100 from the container 17, the external operation device (not shown) opens the manual valve 25. This opens the communication hole 23 as shown in the state of Fig. 4 discharges the gas in the accommodation space S out of the container 17.

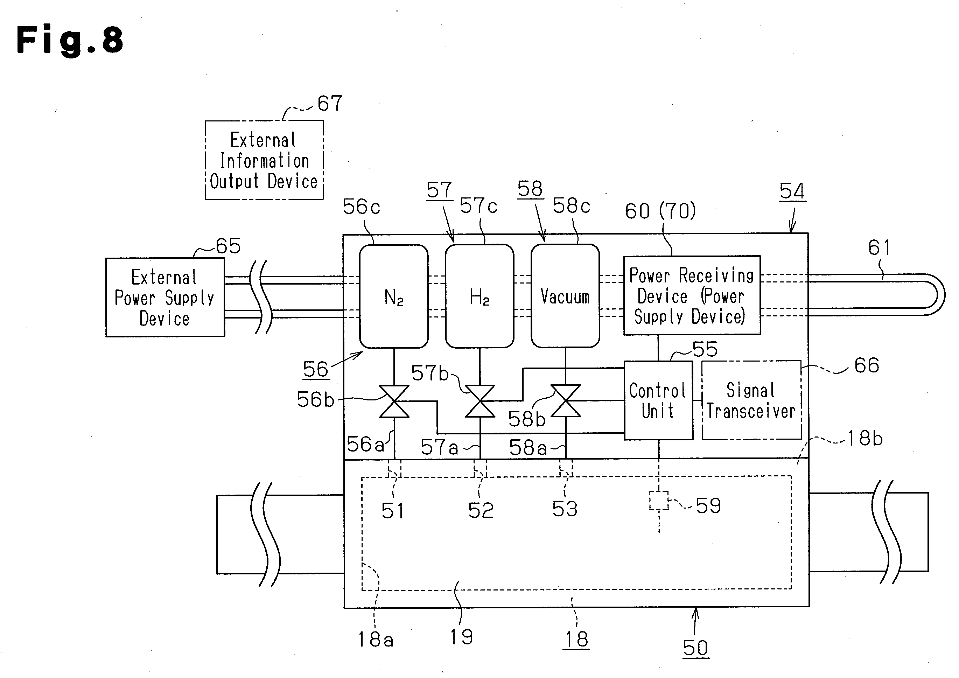

The present embodiment has the advantages described below.
(1) The container 17 includes the communication hole 23, which enables communication of the inside and outside of the container 17. This enables the state inside the container 17 to be controlled from the outside. The atmospheric adjustment device 38 is connected to the container 17 through the communication hole 23 to adjust the internal atmosphere of the container 17 in a state in which the container 17 is substantially sealed. This reduces gas consumption when adjusting the internal atmosphere. Further, the atmospheric adjustment device 38 is externally connected to the container 17. Thus, the container 17 can be used in a production line even if the container 17 is sealed.
(2) The container 17 includes the manual valve 25 for opening and closing the communication hole 23. The manual valve 25 is operated to close the communication hole 23 and seal the container 17. This maintains the internal atmosphere of the container 17 even if the atmospheric adjustment device 38 is separated from the container 17 after adjusting the internal atmosphere. Accordingly, the soldering may be divided into a plurality of processes including the gas replacement process, the heating process, and the cooling process. Further, the cycle time of soldering is reduced, and a production line suitable for mass production of the semiconductor module is realized.
(3) The manual valve 25 operated by the external operating device is arranged in the container 17. That is, the manual valve 25, which functions as an open/close mechanism for the communication hole 23, does not require power to operate. Accordingly, a power supply device for operating the open/close mechanism of the communication hole 23 does not have to be provided for the container 17. This simplifies the structure of the container 17. An electromagnetic valve operable by external power may be arranged in the container 17 in lieu of the manual valve 25.
(4) The piping in the atmospheric adjustment device 38 is configured to enable selective connection of the inert gas supply unit 40, the reducing gas supply unit 41, and the gas discharge unit 42 to the single communication hole 23 of the container 17. This simplifies the structure of the container 17. Further, the container 17 and the atmospheric adjustment device 38 are connected at only one location. This improves the reliability of the device.
(5) In the heating process, the high frequency heating coils 46, which are spaced apart from the weights 35, heats the weights 35. Thus, even when soldering a plurality of semiconductor elements 12 to each circuit board 11, the plurality of bonding portions are heated without having to arrange a high frequency heating coil 46 on each semiconductor element 12. The high frequency heating coils 46 can be handled separately from the weights 35 and the circuit boards 11 when cooling the molten solder. In other words, another semiconductor module 100 may be heated with the high frequency heating coils 46 while cooling the semiconductor module 100 that has been heated by the high frequency heating coils 46. Furthermore, heat is transmitted to a bonding location in a concentrated manner by generating heat in each weight 35 that presses the semiconductor elements 12 to heat the bonding location of the corresponding circuit board 11. Therefore, the solder sheets 33 are heated more efficiently than when heating the entire circuit board 11 or the entire container 17.
(6) In the heating process, the high frequency heating coils 46 are arranged above the weights 35, which are placed directly on the plurality of semiconductor elements 12. Thus, each weight 35 transmits heat along a plane to a plurality of bonding locations in the corresponding circuit board 11. This uniformly heats the plurality of bonding locations in the circuit board 11. As a result, the solder sheets 33 arranged at the plurality of bonding locations starts to melt at substantially the same time and ends melting at substantially the same time. This increases the soldering efficiency.
(7) In the heating process, the high frequency heating coils 46 are arranged outside the container 17. Thus, the use of the high frequency heating coils 46 is restricted only when performing heating during soldering. Accordingly, by exchanging the container 17 facing toward the high frequency heating coils 46 as soon as the high frequency heating coils 46 ends heating, the next soldering can be performed without waiting for the solder to cool. This increases production efficiency. Further, by arranging the high frequency heating coils 46 outside the container 17 instead of inside the container 17, the volume of the container 17 may be minimized to miniaturize the container 17. Further, atmospheric adjustment mainly includes the discharge of air (depressurization) from the container 17, the supply and discharge of inert gas (e.g., nitrogen gas), and the supply and discharge of reducing gas (e.g., hydrogen). Thus, when the volume of the container 17 is reduced, the time required for discharging air can be shortened and the energy consumption required for discharging air, for example, the energy required to operate the vacuum pump 42c, may be decreased. Further, the time required for supplying or discharging inert gas or reducing gas can be shortened and the energy consumption required for supplying or discharging inert gas or reducing gas may be decreased, and the consumption of supplied gas may be reduced.
(8) The portion of the container 17 that faces toward the high frequency heating coils 46, or the cover 19, is formed by the glass plate 22 of an electrically insulative material. This permits the heating of the weights 35 while preventing the heating of the container 17 itself.
(9) The weight 35 includes a plurality of pressurizing surfaces 35a that contacts the non-bonding surfaces of a plurality of semiconductor elements 12. That is, the weight 35 is configured as a single unit corresponding to the plurality of semiconductor elements 12. The weight 35 is arranged on the plurality of semiconductor elements 12. This prevents tilting of the weight 35 when the solder melts and enables soldering to be performed stably compared to when the weight 35 is arranged on only one semiconductor element 12.
(10) When soldering a plurality of circuit boards 11, one high frequency heating coil 46 is arranged in correspondence with each circuit board 11 to heat the weight 35 arranged in the circuit board 11. This is more efficient than when heating a plurality of weights 35, which are arranged on a plurality of circuit boards 11, with only one high frequency heating coil 46.
(11) The formation of a production line SR for the container 17 of the present embodiment enables the semiconductor module 100 to be producted in a production line and realizes mass production. Accordingly, the production efficiency of the semiconductor module 100 can be increased.
   A second embodiment of the present invention will now be discussed with reference to Fig. 8. The same reference numerals are given to those components that are the same as the corresponding components of the first embodiment, and redundant description will be omitted or simplified.
   Fig. 8 shows a container (chamber) 50 used when soldering the semiconductor module 100. The basic structure of the container 50 in the present embodiment is similar to the container 17 of the first embodiment, and the container 50 includes the main body 18, which has the opening 18a, and the cover 19, which opens and closes the opening 18a of the main body 18. Although not shown in Fig. 8, in the same manner as in the first embodiment, the support base 20 is arranged in the main body 18, and the glass plate 22 is attached to the cover 19.
   A plurality of (three in the present embodiment) communication holes 51, 52, and 53 extend through the side wall 18b of the container 50 in the present embodiment. The communication holes 51, 52, and 53 each serve as a communication passage for communicating the inside and the outside of the container 50. The side wall 18b of the container 50 in the present embodiment does not include a valve body corresponding to the manual valve 25. An atmospheric adjustment device 54 is attached to the side wall 18b of the container 50 in the present embodiment.
   The atmospheric adjustment device 54 includes a control unit 55, an inert gas supply unit 56 for supplying inert gas (nitrogen (N₂) in the present embodiment) into the container 50, a reducing gas supply unit 57 for supplying reducing gas (hydrogen (H₂) in the present embodiment) into the container 50, and a vacuum unit 58 for depressurizing the interior of the container 50. The inert gas supply unit 56 includes a pipe 56a, an open/close valve 56b arranged in the pipe 56a, and a nitrogen tank 56c. The reducing gas supply unit 57 includes a pipe 57a, an open/close valve 57b arranged in the pipe 57a, and a hydrogen tank 57c. The vacuum unit 58 includes a pipe 58a, an open/close valve 58b arranged in the pipe 58a, and a vacuum tank 58c that is depressurized in advance. The pipe 56a of the inert gas supply unit 56 is connected to a communication hole 51 of the container 50 by a seal (not shown). The pipe 57a of the reducing gas supply unit 57 is connected to a communication hole 52 of the container 50 by a seal (not shown). The pipe 58a of the vacuum unit 58 is connected to a communication hole 53 of the container 50 by a seal (not shown).
   The control unit 55 is connected to each of the open/close valves 56b, 57b, and 58b. Various sensor groups 59, which are arranged in the container 50, are connected to the control unit 55. The sensor group 59 includes a temperature sensor such as a thermocouple for measuring the temperature in the container 50 (in particular, the temperature at a solder bonding portion) or a pressure sensor for measuring the pressure inside the container 50. A power receiving device 60 supplied with power from the external power supply device 65 in a non-contact state is connected to the control unit 55. The power receiving device 60 is arranged in the atmospheric adjustment device 54. The atmospheric adjustment device 54 adjusts the atmosphere in the container 50 by supplying gas to and discharging gas from the container 50.
   The container 50 of the present embodiment is conveyed together with the atmospheric adjustment device 54 on a conveyor 36, which serves as a conveyance mechanism and which is arranged in the production line SR. The production line SR of the present embodiment includes a power supply line 61 connected to the external power supply device 65. The power receiving device 60 of the atmospheric adjustment device 54 is supplied with power from the power supply line 61 in a non-contact state. In this manner, the power receiving device 60 and the power supply line 61 supplies the atmospheric adjustment device 54 of each container 50 with power when conveyed by the conveyor 36 and enables the atmospheric adjustment device 54 to execute a predetermined control. Specifically, the container 50 of the present embodiment that includes the atmospheric adjustment device 54 can perform a gas replacement process while being conveyed on the conveyor 36.
   In the same manner as the production line SR described in the first embodiment, a work area E2 for a heating process and a work area E3 for a cooling process are provided in the production line SR of the present embodiment. In the same manner as in the first embodiment, when the container 50 reaches the work area E2, high frequency induction heating is carried out to perform the heating process. When the container 50 reaches the work area E3 after the heating process ends, the cooling process is performed in the same manner as in the first embodiment. The contents of soldering (including the contents of the control executed by the atmospheric adjustment device 54) in the present embodiment, that is, the gas replacement process, the heating process, and the cooling process are similar to the first embodiment and thus will not be described. The container 50 of the present embodiment does not include a valve body. Thus, control related to the valve body and executed in the first embodiment, that is, the open/close control of the manual valve 25, is omitted.
   In addition to the advantages (1), (2), and (5) to (11) of the first embodiment, the present embodiment has the advantages described below.
(12) The container 50 and the atmospheric adjustment device 54 are connected so that they are integrally movable. The container 50 is conveyed together with the atmospheric adjustment device 54. Accordingly, the time for connecting the atmospheric adjustment device 54 to the container 50 is not necessary. This enables reduction in the cycle time related to soldering and obtains a production line suitable for mass production of the semiconductor module.
(13) The container 50 is conveyed together with the atmospheric adjustment device 54. Thus, the internal atmosphere of the container 50 can be adjusted when necessary in accordance with the measurement results of internal temperature, internal pressure, and the like measured by the sensor group 59. In other words, the internal atmosphere of the container 50 can be adjusted even while being conveyed regardless of the work areas E1 to E3 to which the container 50 has moved.
(14) The power receiving device 60 and the power supply line 61 are employed. This enables the atmospheric adjustment device 54 to be supplied with the necessary power for adjustments while moving together with the container 50. Thus, the supply of power and various adjustments may be performed without having to stop the container 50 and the atmospheric adjustment device 54 at a predetermined location in the production line SR. This eliminates the need for time during which the container 50 is stopped at a predetermined location and reduces the cycle time related to soldering. In the present embodiment, the internal atmosphere of the container 50 may be adjusted during movement between processes. This enables further reduction of the cycle time.

Each of the above embodiments may be modified as described below.

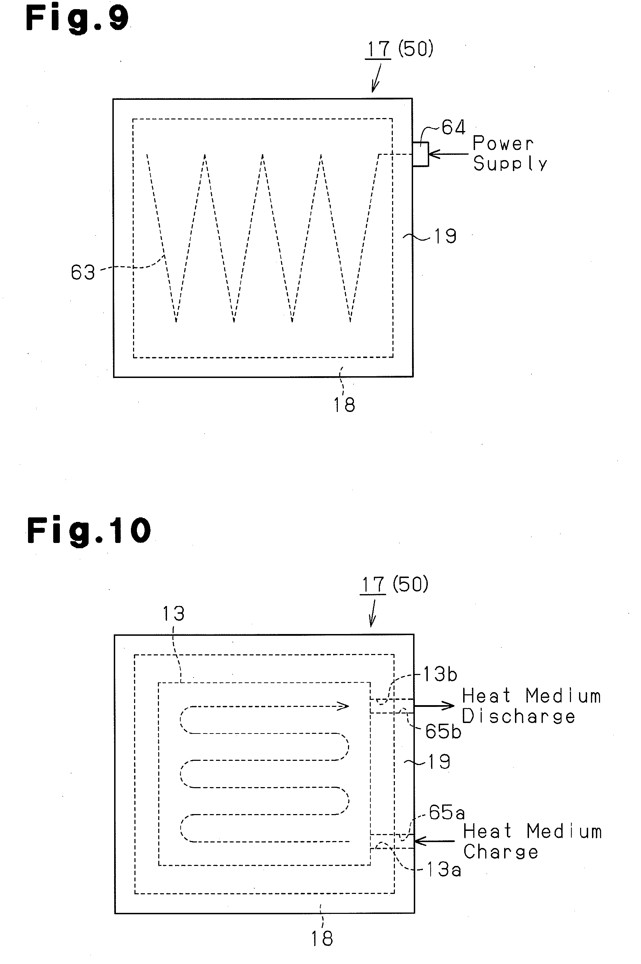

Heating is performed by carrying out high frequency induction heating in the heating process of each embodiment. However, the heating method performed by carrying out high frequency induction heating may be changed to a heating method that is shown in Fig. 9 or Fig. 10. Fig. 9 schematically shows a method for performing heating with the use of a heater 63 arranged in the container 17 (50). In this case, power must be supplied to the heater 63. Thus, a connection terminal 64 is arranged on the container 17 (50), and power is externally supplied to the heater 63 through the connection terminal 64.

Fig. 10 schematically shows a method for supplying the heat sink 13 of the semiconductor module 100 accommodated in the container 17 (50) with a heat medium, for example, hot and pressurized hydrogen gas to heat the semiconductor module 100. In this case, the container 17 (50) includes a heat medium inlet hole 65a and a heat medium outlet hole 65b respectively connected to a supply port 13a and a discharge port 13b formed in the heat sink 13. A valve body (not shown) opens and closes each of the heat medium inlet hole 65a and the heat medium outlet hole 65b. In this structure, the heat of the heat medium charged into the heat sink 13 is transmitted to the solder sheet 33 through the heat sink 13 and the circuit board 11. This heats the solder sheet 33. The heat medium is charged into the heat sink 13 through the heat medium inlet hole 65a and the supply port 13a, circulated in the heat sink 13, and then discharged out of the container 17 (50) through the heat medium outlet hole 65b and the discharge port 13b.

The soldering subject may be a circuit board 11 that is not bonded with the heat sink 13. In this case, a semiconductor device including the circuit board 11 and the semiconductor elements 12 is accommodated in the container 17 (50) to perform soldering. Further, the semiconductor module 100 serving as the soldering subject includes six circuit boards 11. However, the number of circuit boards 11 arranged on the semiconductor module 100 may be changed.

The cover 19 may be of a type that is removable from the main body 18 or of a type that can open and close.

The portion of the cover 19 facing toward the high frequency heating coil 46 may be formed from an electrically insulative material other than glass, for example, ceramics or resin. The cover 19 may be formed from a complex material (GFRP: glass fiber reinforced plastics) of glass fiber and resin if there is a necessity to increase the strength of the cover 19 so that the cover 19 can withstand the pressure difference between the inside and outside of the container 17. Further, the cover 19 may be formed from a non-magnetic metal. When using metal for the cover 19, metal having a higher electrical resistance than the weight 35 is preferably used. Further, the cover 19 may be formed from a complex material of metal and an insulative material.

The high frequency heating coil 46 may be shaped so as to extend along the conveying path of the container 17 (50) in the production line SR. Alternatively, a plurality of high frequency heating coils 46 may be arranged along the conveying path of the container 17 (50). In such cases, the container 17 (50) is heated as it is conveyed on the conveyor 36.

In the first embodiment, a communication hole and a valve body (manual valve 25) may be arranged in the side wall 18b of the container 17 for each of the pipes 40a, 41a, and 42a of the atmospheric adjustment device 38. Since three pipes 40a, 41a, and 42a are arranged in the atmospheric adjustment device 38 of the first embodiment, three communication holes and three valve bodies would be arranged in the side wall 18b of the container 17.

The first embodiment may include only the communication hole 23 that is formed in the side wall 18b of the container 17 and omit the manual valve 25. In this case, the communication hole 23 of the container 17 is constantly open. Thus, at least either one of the gas replacement process and the heating process is performed at one location.

When carrying out high frequency induction heating to perform the heating method of the second embodiment, the high frequency heating coil 46 may be arranged inside or outside the container 50 (above cover 19), and the high frequency heating coil 46 may be supplied with power from the power supply line 61.

In the second embodiment, the vacuum tank 58c arranged in the atmospheric adjustment device 54 may be changed to a vacuum pump.

In the second embodiment, instead of the power supply line 61 and the power receiving device 60, a power supply device 70 (see Fig. 8) such as a battery may be installed in the atmospheric adjustment device 54, and power may be supplied from the power supply device to the control unit 55. Further, power may be transferred through contact between the power supply line 61 and the power receiving device 60.

In the second embodiment, the atmospheric adjustment device 54 may include a signal transceiver 66 (see Fig. 8) for exchanging information related to atmosphere control with an external information output device 67 (see Fig. 8) such as a management computer in a factory where the production line SR is installed. Furthermore, in the second embodiment, instead of using the power supply line 61 and the power receiving device 60, the signal transceiver 66 may be installed in the atmospheric adjustment device 54 when the power supply device 70 is arranged in the atmospheric adjustment device 54. The signal transceiver 66 is connected to the control unit 55 of the atmospheric adjustment device 54. The signal transceiver 66 may be a device that exchanges signals with the external information output device 67 in a non-contact state such as a wireless communication device. Further, the signal transceiver 66 may be a device for exchanging signals with the external information output device 67 in a contact state such as a device connected to the external information output device 67 by a signal transmission line. In such a structure, the atmospheric adjustment device 54 conveyed on the conveyance mechanism (conveyor 36) together with the container 17 obtains information necessary to perform adjustments via the signal transceiver 66. Accordingly, the atmospheric adjustment device 54 can automatically adjust the internal atmosphere of the container 17, the cycle time related to soldering can be shortened, and soldering efficiency can be improved.

In the first and second embodiments, a reducing gas atmosphere of 100% hydrogen is formed in the container 17 during the heating process. However, heating may be performed by filling the container 17 with gas including reducing gas. For example, the container 17 may be filled with gas prepared by mixing 3% of hydrogen, which serves as a reducing gas, with nitrogen, which serves as an inert gas.

## Claims

1. A soldering container configured to be conveyed by a conveyance mechanism during soldering in a state accommodating a soldering subject, the container comprising:
a sealable container body for accommodating the soldering subject, with the container body including at least one communication passage enabling communication between the inside and outside of the container body, wherein the container body is configured to be connectable to an atmospheric adjustment device for adjusting an internal atmosphere of the container body through the communication passage.

2. The container according to claim 1, further comprising:
a switching unit arranged in the communication passage, with the switching unit switching the communication passage between an open state and a closed state to connect and disconnect the inside and outside of the container body.

3. The container according to claim 2, wherein the switching unit is an externally operable manual valve.

4. The container according to claim 1, wherein the container body and the atmospheric adjustment device are connected to be integrally movable by the conveyance mechanism.

5. The container according to claim 4, wherein the atmospheric adjustment device includes either one of a power supply device and a power receiving device, which is supplied with power from an external power supply device.

6. The container according to claim 4 or 5, wherein the atmospheric adjustment device includes a signal transceiver for exchanging information related to atmosphere control with an external information output device.

7. A production method of a semiconductor device by soldering a semiconductor element to a circuit board, the production method comprising:
accommodating in a sealable container body a soldering subject in which the semiconductor element is arranged on the circuit board with solder located therebetween, with the container body including at least one communication passage enabling communication between the inside and outside of the container body;
conveying the container body accommodating the soldering subject with a conveyance mechanism;
supplying the container body with atmosphere gas containing reducing gas through the communication passage from an atmospheric adjustment device connected to the container body to fill the container body with the atmosphere gas;
raising the temperature in the container body to a temperature that is higher than or equal to a melting point of the solder in a state in which the container body is filled with the atmosphere gas to melt the solder; and
solidifying the molten solder by lowering the temperature in the container body to a temperature that is lower than the melting point to solder the semiconductor element to the circuit board.

8. The production method according to claim 8, further comprising:
switching the communication passage between an open state and a closed state with a switching unit arranged in the communication passage to connect and disconnect the inside and outside of the container body.

9. The production method according to claim 8, further comprising:
integrally moving the container body and the atmospheric adjustment device, which are connected to each other, with the conveyance mechanism.

10. The production method according to claim 9, further comprising:
exchanging information related to atmosphere control between the atmospheric adjustment device and an external information output device.
